# EUROPEAN PATENT SPECIFICATION

(11) **EP 0 348 954 B1**
(45) Date of publication and mention of the grant of the patent: **16.06.1993**
(21) Application number: 89111799.6
(22) Date of filing: 28.06.1989
(51) Int. Cl.: H01R 9/07

(54) **Electrical connection arrangement for flat cable**
Elektrische Verbindungsanordnung für Flachkabel
Agencement de connexion électrique pour câble plat

(30) Priority: 30.06.1988 JP 165367/88
(43) Date of publication of application: 03.01.1990
(73) Proprietor: SUMITOMO WIRING SYSTEMS, LTD., Yokkaichi City Mie 510 (JP)
(72) Inventor: Yamamoto,Tetsuo, Yokkaichi City Mie 510 (JP); Moriai,Yasuharu, Suzuka City Mie 513 (JP); Kusumoto,Kuniharu, Kanagawa 243 (JP); Yamamoto, Morichika, Utsunomiya City Tochigi 321 (JP); Wada,Tetsuaki, Mie 511-03 (JP)
(74) Representative: KUHNEN, WACKER & PARTNER

(56) References cited:
- EP-A- 0 243 998
- DE-A- 2 932 966

## Description

The present invention relates to a connection arrangement for making an electrical connection between electrical circuits of a multiconductor flexible printed circuit wherein a group of substantially parallel stripes of electrical circuits are formed on one or both sides of an electrical insulation sheet.

Flexible printed circuitries and flat multi-conductor cable are generally called flexible cable where conductive circuit patterns are formed on either or both sides of a flexible sheet or film of polymeric material with electrically isolating capability.

There are several methods for making electrical connections between conductors of the flexible cable, in which interfacial connection technologies for printed circuit boards (PCB) are applied. As described in page 102 of the original text " Printed Circuit, Design and Drafting " of J.S. Cook **II** (TAD Institute, Cambridge, Mass., U.S.A. published in 1967 by the Associated Designers, Inc), three typical methods for making interfacial connections are used:
(1) a wire lead
(2) a flared eyelet
(3) a plated through hole

Wire lead connection is a classical but still widely used method for making connections by direct soldering of the wire lead to the cable conductor. During the soldering process, the substrate sheet or film tends to be exposed to an excess of heat and subsequent deformation of the circuit end may occur.

The second method of connection uses a flared eyelet in which most reliable interconnection is achieved except that this utilizes a silver eyelet having unique structure which causes problems in connection cost and in productivity of connected product.

Plated through hole is highly recommended for making interconnections between two circuit patterns which are formed on both sides of an insulating material.

In modern electronic-packaging practice for high density electronic devices in which signal circuits are predominant in a whole circuit package, plated through hole is an essential tool for inter-connection.

DE-A-29 32 966 discloses a distributor comprising a hard plate-like substrate carrying fixedly interconnected sets of upright standing connectors which can be contacted with separate cables.

GB-A-1,146,807 discloses a connector for a flat conductor cable having parallely running, embedded conductors. A desired conductor of the flat cable can be contacted by means of an externally applied conducting piece which thrusts through the insulation of the flat cable and makes direct contact with the desired conductor.

U.S. Patent 4,249,303 discloses a method for electrical connection of flat cables which is characterized in selection of a preferred connection zone by referring to a matrix of connection zones provided by placing one flat cable atop of another.

In U.S. Patent 4,249,304 there is described a method of connecting electric cables through perforations in overlapping cable portions followed by inserting an electric connector through the perforation and then electrically connecting the connector to each of the overlapping conductors.

In the summary of the invention, inventor mentioned that inasmuch as the connector was inserted through the perforation, there was no need to provide the connector with a metal piercing edge or to make it strong enough to pierce the conductors.

A crimpable connecting device for flat conductor cable is described in U.S. Patent 3,395 381 and is characterized in having an U-shape. The conductor is pinched between the lances and the edges of the inwardly bent sidewalls.

It is an object of the present invention to provide a reliable interconnection between desired circuits in a flexible circuit pattern by means of another flexibe connection circuit overlapped with insulation layer therebetween, wherein U-shaped connection probes of electro-conductive metal are used for making electrical connections between the two circuit layers.

It is a more particular object of the subject invention to offer a connection arrangement for flexible printed circuitries with multiconductor wherein a group of parallel lines of etched or stamped conductors are formed either on one side or on both sides of thermoplastic synthetic polymeric material. The connection circuit having a circuit pattern with the same numbers of connection circuit ends as those of the conductors to be connected and having interconnective circuit portions are overlapped on the flexible printed circuitries in such a way that each of the connection circuit ends are placed on a top of the mating conductor in the flexible printed circuitries and that a each of the interconnective circuits is placed across parallel lines of conductors to be connected in the flexible circuitries.

The connection circuit can be made by etching or stamping a plastic sheet laminate of copper foil or strip according to a conventional method and suitable circuit pattern can easily be designed by comparison with that of the flexible circuit to receive connection. A further advantage of the present invention is attained by designing the circuit in such a way that all of the connection circuit end portions are aligned along a common line which is perpendicular to the direction of circuitries in the flexible printed circuitries, since electrical connection between mating conductors in two circuit patterns can be made by machine through a few simple processes of perforating, connection probe insertion and compression.

A U-shaped connection probe of copper is quite suitable and preferrably its edge portion of side walls are sharpened in order to penetrate the insulation sheet or to be thrusted into conductors when compressed.

The desirable features of the connection arrangement of the present invention is further described in details by referring to the drawings and will become apparent from the following description of a preferred embodiment.

It should be noted that the concept of the connection arrangement of the present invention can be applied for a variety of processes of circuit connection wherein a plurality of electrical conductors are placed on either one or both sides of an electrical insulating sheet or film. It is, therefore, evident that many applications become possible within the scope of the present invention.

Fig.1 is a perspective view of a connection arrangement for flat cable of the present invention.

Fig.2 is a schematic view illustrating application of the two circuit patterns in a crossing and counterfacing relationship having an insulation sheet therebetween.

Fig.3 is a perspective view of the connection probe used in the present invention.

Fig.4 is a plan view of a connection probe used in the present invention.

Fig.5 is a side view of the connection probe used in the present invention.

Fig.6 is a cross-sectional view of the bottom portion of the connection probe along line **VI∼VI** in Fig.4.

Fig.7 is a perspective view illustrating a group of connection probes under their production stage.

Fig.8 illustrates a cross-sectional view of the connection arrangement of the present invention taken along the line **VIII∼VIII** in Fig.1.

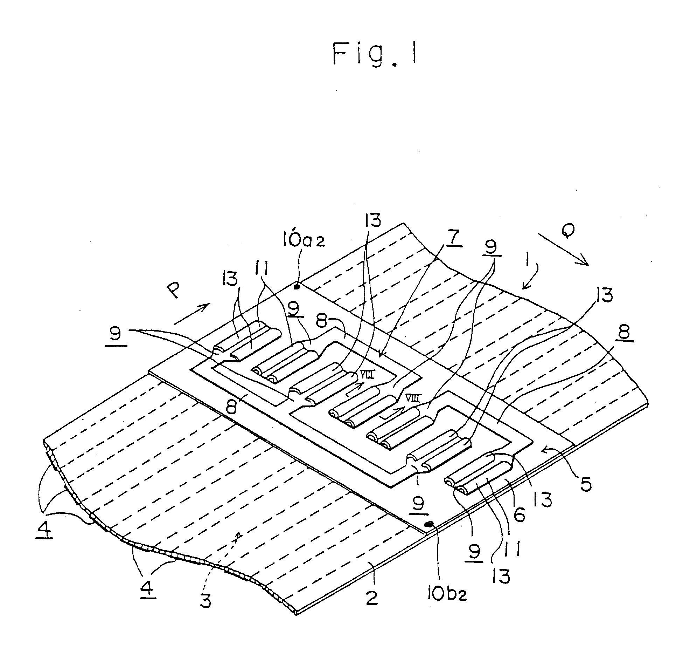

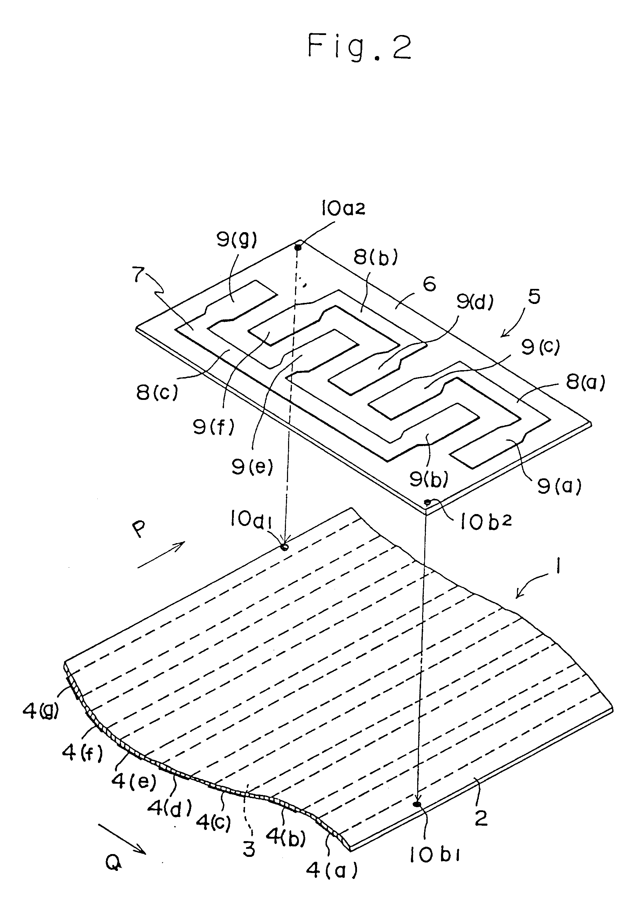

Fig.1 shows a perspective view of the connection arrangement of the present invention and an exploded perspective view of the same is shown in Fig.2. A flexible printed circuit (1) consists of an insulation sheet (2) (the first insulation sheet) of thermoplastic polymeric material such as polyethylene, polyethylene terephthalate, fluorinated polyethylene-propylene co-polymer with or without aromatic polyimide film as substrate.

On the back side of the first insulation sheet(2) there is formed an electrical lead pattern (3) (the first circuit pattern) having a group of substantially linear circuit stripes (4) of electrical conductive circuit of copper (circuit stripes 4(a) to 4 (g)) located with a predetermined center to center spacing. The electrical lead pattern (3) is prepared by conventional method of printed circuit manufacture such as etching or die-stamping of laminate of copper and plastic polymer sheet. As illustrated in the example shown in Fig.1 and Fig.2. the flexible printed circuit (1) has a plenty of linear circuit stripes (4(a) to 4 (g)) all of which are oriented along circuit length direction **P**.

A connection circuit (5) which is placed on top of the flexible printed circuit (1) consists of an insulation sheet (6) (the second insulation sheet) of the same insulation material used in the first insulation sheet (2) and another electrical lead pattern (7) (the second circuit pattern) which is formed on the top surface of the second insulation sheet (6). The second electrical lead pattern (7) of the connection circuit (5) is best illustrated in Fig.2 where it includes a set of interconnective electrical circuit portion (8) including 8(a), 8(b), and 8(c) for making circuit-bridges between desired circuit stripes selected from 4(a) to 4(g), and group of connection terminal 9(a) to 9(g) whose number is equal to that of the selected circuits stripes in the first circuit patterns to be connected. As shown in Fig.2, the interconnective electrical circuit portions 8(a), 8(b) and 8(c) are designed by a conventional printed circuit fabricating technique in such a way that they can cross over at least a pair of the circuit stripes to be connected. Further, the connection terminals 9(a) to 9(g) of the second circuit pattern (7) are located on a common line which is substantially parallel to the interconnective circuit (8) and are aligned to have the same distance between their lengthwise center lines as that of the circuit stripes (4) of the first circuit pattern (3) while the width of all of the connection terminals is same and is designed to be substantially equal to that of the circuit stripes (4).

The above described design features of the first and the second circuit pattens (3), (7) are described in more details with reference to Fig.1 and Fig.2.

In a typical practice of making the connection arrangement of the present invention, the connection circuit (5) is placed on the top of the flexible printed circuit (1) in such a way that their insulation sheets (2) and (6) are facing and thus both circuit patterns (3) and (7) are electrically isolated by the two sheets of plastic polymeric materials. Two pairs of perforations (10a1) and (10a2), (10b1) and (10b2) are brought into engagement for correct positioning of the two circuit members of (1) and (5) utilizing positioning pins having suitable diameter so that connection terminals 9(a), 9(c) cover circuits 4(a) and 4(c) respectively making interconnective electrical circuit portion 8(a) hang across the two circuit stripes 4 (a) and 4(c). Other connection terminals 9(d), 9(f) are similarly placed on the top of circuit stripes 4(d) and 4(f) with interconnective electrical circuit portion 8(b) therebetween. As for three connection terminals 9(b), 9(e) and 9(g), they are placed over the circuit stripes of 4(b) , 4(e), and 4(g) respectively where common interconnective electrical circuit portion 9(c) is crossing the said three circuit stripes.

As mentioned previously, the circuit stripes 4 have a parallel alignment along direction **P** and as the interconnective electrical circuit (8) has also been placed in parallel direction, the connection terminals (9a) to 9(g) lie on the top positions with respect to every circuit stripe in underlying circuit stripes 4(a) to 4(g), respectively leaving all interconnective electrical circuits portions 8(a), 8(b), and 8(c) across the corresponding circuit stripes along a direction **Q** which is substantially perpendicular to the lenghtwise direction **P** of circuit stripes (4).

In order to achieve rigid and reliable electrical connection within a connection arrangement of the present invention, the two facing sheets of polymeric material are usually bonded together through either thermal fusion or adhesive bonding followed by treatment by a thermal press.

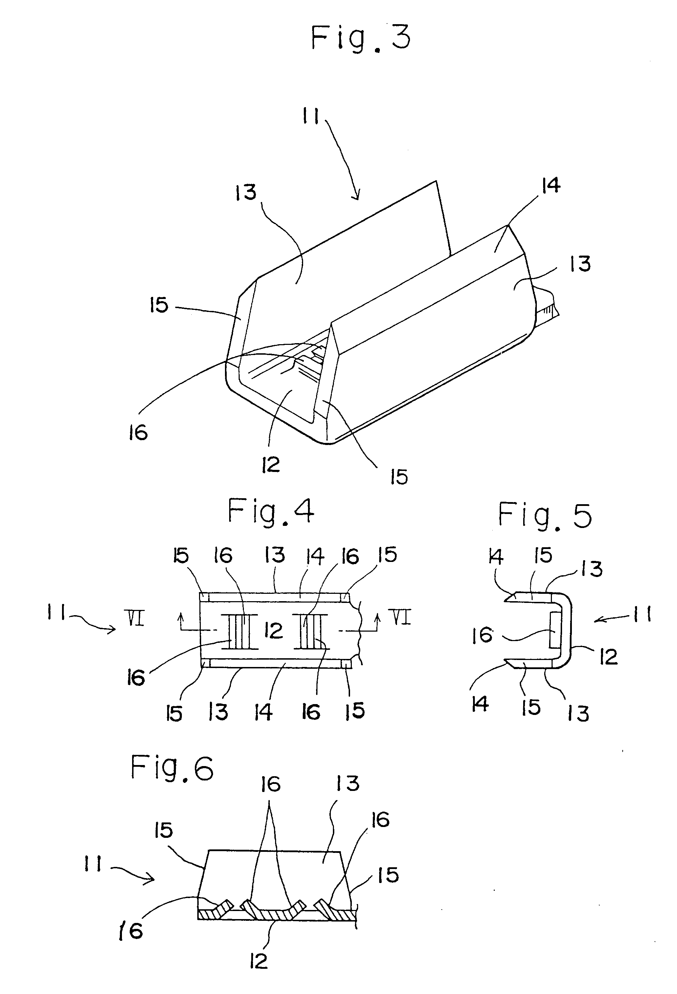

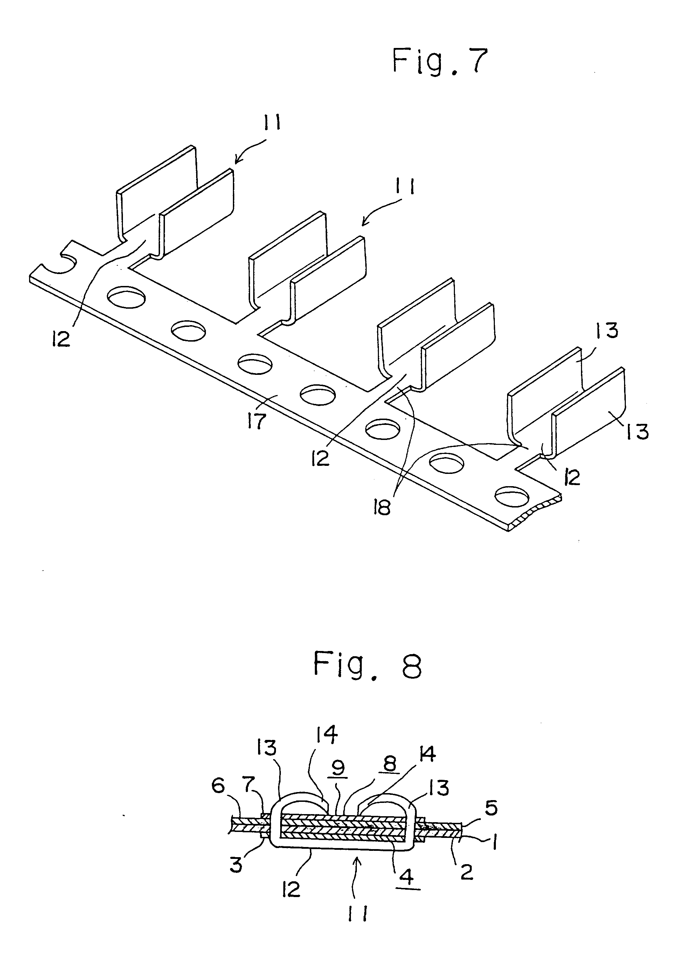

Fig.3 shows a perspective view of the connection probe (11) used for making electrical connection between the first circuit pattern (3) and the second circuit pattern (7). A set of connection probes (11) is originally fabricated through die-stamping process out of a sheet of electro-conductive metal such as copper or copper alloy followed by compression forming to a U-shape, and as shown in Fig.7 the probes are connected to one common lead frame (17) at their neck portions (18) where each of the connection probes (11) can be separated by cutting.

Structural features of the probe (11) are shown in its plan view (Fig.4), side view (Fig.5) and cross-sectional view (Fig.6) the latter being taken along line **VI∼VI** in Fig.4. The top portions (14) of the side walls (13) are sharpened in order to obtain reliable, firm contact to the connection terminal (9) of the second circuit pattern (7) by thrusting into the terminal when the walls (13) are compressively turned inwardly. On the bottom of the probe (11) there are two ditches. Both the neighbouring zones of the ditch form wedges (16) which will make stable contact to the corresponding circuit stripe (4) in the first circuit pattern (3) by compression.

The tapered probe edges (15) at the front and rear portions of the side walls (13) assist the sharpened top portions (14) to make strong contact or thrusting to the connection terminal (9) in the second circuit pattern (7).

In practice, two circuits of (1) and (5) are combined by bonding and desired connection portions, namely circuit stripes (4) and mating connection terminals (9), are punched out to provide slits for insertion of connection probes (11). The bottom portion (12) of the probe (11) is firmly pressed onto the outer surface of the circuit stripe (4) achieving firm contact of the wedges (16) and further the side walls are bent inwardly so that their sharpened top portions come into a strong oppression to the top surface of the connection terminal (9) of the connection circuit (5) which will result in thrust of the copper layer of terminal (9). The above described contact relationship is best illustrated in a cross-sectional view shown in Fig.8 which is taken along line **VIII∼VIII** in Fig.1 showing a perspective view of the connection arrangement of the present invention.

As described above, it is an advantageous feature of the connection arrangement of the present invention that connection of the desired circuit stripe (4) in the flexible printed circuit (1) is made without any soldering process, none of the insulation sheets is exempted from excess heat treatment which often causes thermal distortion of polymeric material of a plastic nature.

Another favourable characteristics of the present invention is that the connection circuit can be fabricated by an equivalent process to that of flexible printed circuit and that both the flexible printed circuit (1) and connection circuit (5) can be designed and fabricated according to almost the same process and by the same kind of manufacturing facilities and thus production management in terms of quality and quantity becomes very easy and controllable.

Further it should be mentioned that due to freedom of circuit design connections or branchings of the circuit pattern (3) in flexible printed circuit (1) can easily be achieved by designing and fabrication of corresponding pattern of connection circuit (5) through conventional method used in electronic packaging device manufacture.

Finally a plenty of connections of the circuit patterns (3) and (7) can be achieved simultaneously by mere insertion and compression of U-shaped connection probe (11) at predetermined, desired circuit portions.

As described in the foregoing example positioning of the first and the second circuit patterns is one of the important factors to achieve a compact and reliable connection. Also important background technology is design of second circuit pattern (7) in the connection circuit (5). For instance, the connection terminal (9) can be divided into two groups, and terminals belonging to the first group are aligned on one common line which is parallel to the direction **Q** and remaining terminal group (the second group) is placed on another common line which is also parallel to the direction **Q**.

In the foregoing example the first circuit pattern (3) is formed on the backside of the first insulation sheet (2) and two insulation sheets of (2) and (6) are in counterfacing relationships to each other and thus circuit patterns are isolated by the two insulation sheets. When either one of the circuit patterns of (3) and (7) faces the supporting insulation sheet of another circuit pattern, sharpened top portions (14) and wedges (16) can be firmly contacted to the circuit patterns respectively.

As understood by above description, various modifications and combinations are possible within scope of the connection arrangement of the present invention. The connection circuit with insulating layer is placed on the top of the multi-conductor flexible printed circuit having another insulating layer in a way that both circuits are electrically isolated and that the connection terminals in the connection circuit are laid over the circuit stripes of the flexible printed circuit respectively and after adjusting two circuit positions and most probably after bonding insulation sheets together, U-shaped connection probes are applied to achieve stable mechanical connection between the two circuits.

### List of reference numerals

- 1.: flexible print circuit
- 2.: the first insulation sheet
- 3.: electrical lead pattern (the first circuit pattern)
- 4.: circuit stripes (4(a) ∼4(g))
- 5.: connection circuit
- 6.: the second insulation sheet
- 7.: electrical lead pattern (the second circuit pattern)
- 8.: interconnective electrical circuit portion (8) (8(a), 8(b), 8(c))
- 9.: connection terminal (9(a), to 9(g))
- 10.: perforation (10(a1), 10(a2); 10(b1), 10(b2))
- 11.: connection probe
- 12.: bottom portion
- 13.: side walls
- 14.: top portion
- 15.: probe edge
- 16.: wedge
- 17.: lead frame
- 18.: neck portion

## Claims

1. An electrical connection arrangement for flat cable (1) comprising:
a connection area of the flat cable (1) where a first electro-conductive circuit pattern (3) having substantially parallelly aligned stripes (4a-4g) is formed on at least one side of an electrical insulation sheet (2) of sythetic polymeric material;
a connection circuit (5) having a second electro-conductive circuit pattern (7) formed on a second insulation sheet (6) of synthetic polymeric material with or without another overlaid insulation sheet, said second circuit pattern (7) having interconnective circuit portions (8) that cross over at least two parallel stripes (4a-4g) of the underlying first electro-conductive circuit pattern (3) when the second insulation sheet (6) is placed atop the first insulation sheet (2);
a plurality of U-shaped connection probes (11) of electro-conductive metal for making electrical contact between the first and the second electro-conductive circuit patterns (3,5) after they have been placed in a counterfacing position with at least one of said electrical isolation sheets (2,6) therebetween in such a manner that each of the sidewalls (13) of the connection probes (11) first pass through a pair of vertically mated circuit portions in the two circuit patterns (3,5) respectively and then the sidewalls (13) are turned inwardly by compression so as to have top end portions (14) of the bent sidewalls (13) thrust into the electrical lead circuits of the second electro-conductive circuit pattern (5) of the flat cable respectively, while the flat bottom portion (12) of the connection probes (11) is pressed against the corresponding circuit portions in the first circuit pattern (3).

2. The connection arrangement of claim 1 wherein the second electro-conductive circuit (5) is composed of at least a pair of interconnective electrical circuit portions (8) and at least a pair of connection terminals (9).

3. The connection arrangement of claim 2 wherein the interconnective electrical circuit portions (8) are aligned along a line which is perpendicular to the direction of the underlying first electro-conductive circuit pattern (3).

4. The connection arrangement of claim 1, 2 or 3, wherein the two insulation sheets (2,6) are made of the same thermoplastic polymeric material which can be bonded together either by thermal fusion at their facing surfaces or by suitable adhesives under pressure before making electrical connection between the circuit patterns (3,5) which are formed on each of the insulation sheets (2,6) respectively.

5. The connection arrangement of anyone of the preceding claims wherein the facing position of the two electro-conductive circuit patterns (3,5) is adjusted by at least two pairs of perforations (10) provided in each of the counterfacing insulation sheets (3,5).

6. The connection arrangement of anyone of the preceding claims wherein the connection probe (11) have wedges (16) at their bottoms, said wedges (16) thrusting into the electrical circuit of the flat cable.

7. The connection arrangement of anyone of the preceding claims wherein the top portions (14) of the sidewalls (13) of the connection probes (11) are sharpened enough to thrust into the connection terminal in the connection circuit (5) which is overlying on the first circuit pattern (3) in the flat cable (1).

8. The connection arrangement of anyone of the preceding claims wherein the spacing between two adjacent connection terminals (9) is substantially equal to that of the mating circuit stripes (4a-4g) of the first circuit pattern (3) in the flat cable (1).

## Patentansprüche

1. Elektrische Verbindungsanordnung für ein flaches Kabel (1) mit:
einem Verbindungsbereich des flachen Kabels (1), bei dem ein erstes elektrisch leitendes Schaltungsmuster (3) mit im wesentlichen parallel ausgerichteten Streifen (4a bis 4g) auf zumindest einer Seite eines elektrisch isolierenden Blatts (2) aus synthetischem Polymer-Material ausgebildet ist,
einer Verbindungsschaltung (5) mit einem zweiten elektrisch leitenden Schaltungsmuster (7), das auf einem zweiten isolierenden Blatt (6) aus synthetischem polymerem Material mit oder ohne einem weiteren überlagerten isolierenden Blatt ausgebildet ist, wobei das zweite Schaltungsmuster (7) verbindende Schaltungsabschnitte (8) besitzt, die über zumindest zwei parallele Streifen (4a - 4g) des darunterliegenden ersten elektrisch leitenden Schaltungsmusters (3) hinweglaufen, wenn das zweite isolierende Blatt (6) auf dem ersten isolierenden Blatt (2) aufgebracht ist,
einer Mehrzahl von U-förmigen Verbindungsstücken (11) aus elektrisch leitendem Metall zur Herstellung elektrischen Kontakts zwischen dem ersten und dem zweiten elektrisch leitenden Schaltungsmuster (3, 5) nach deren Anordnung in einer voneinander abgewandten Position mit zumindest einem der elektrisch isolierenden Blätter (2, 6) dazwischen, wobei die Herstellung des elektrischen Kontakts derart erfolgt, daß jede der Seitenwände (13) der Verbindungsstücke (11) zunächst jeweils durch ein Paar von vertikal passend ausgerichteten Schaltungsbereichen in den beiden Schaltungsmustern hindurchgeht und dann die Seitenwände (13) durch Zusammendrücken einwärts gewendet werden, derart, daß die oberen Endbereiche (14) der gebogenen Seitenwände (13) jeweils in die elektrischen Leiterschaltungen des zweiten elektrisch leitenden Schaltungsmusters (5) des flachen Kabels eindringen, während der flache Bodenbereich (12) der Verbindungsstücke (11) gegen die entsprechenden Schaltungsbereiche im ersten Schaltungsmuster (3) gedrückt wird.

2. Verbindungsanordnung nach Anspruch 1, bei der die zweite elektrisch leitende Schaltung (5) aus zumindest einem Paar von verbindenden elektrischen Schaltungsbereichen (8) und zumindest einem Paar von Verbindungsanschlüssen (9) zusammengesetzt ist.

3. Verbindungsanordnung nach Anspruch 2, bei der die verbindenden elektrischen Schaltungsbereiche (8) entlang einer Linie ausgerichtet sind, die rechtwinklig zur Richtung des darunterliegenden ersten elektrisch leitenden Schaltungsmusters (3) verläuft.

4. Verbindungsanordnung nach Anspruch 1, 2 oder 3, bei der die beiden isolierenden Blätter (2, 6) aus demselben thermoplastischen polymeren Material hergestellt sind, das entweder durch thermische Verschmelzung an ihren einander zugewandten Oberflächen oder durch geeignete Klebmittel unter Druck miteinander verbindbar ist, bevor eine elektrische Verbindung zwischen den Schaltungsmustern (3, 5), die jeweils auf jedem der isolierenden Blätter (2, 6) ausgebildet sind, hergestellt wird.

5. Verbindungsanordnung nach einen der vorhergehenden Ansprüche, bei dem die einander zugewandte Position der beiden elektrisch leitenden Schaltungsmuster (3, 5) durch zumindest zwei Paare von Perforationen (10) justiert wird, die in jedem der einander zugewandten bzw. abgewandten isolierenden Blätter (3, 5) vorgesehen sind.

6. Verbindungsanordnung nach einem der vorhergehenden Ansprüche, bei dem das Verbindungsstück (11) Keile (16) an seinen Böden besitzt, wobei die Keile (16) in die elektrische Schaltung des flachen Kabels eindringen.

7. Verbindungsanordnung nach einem der vorhergehenden Ansprüche, bei dem die oberen Bereiche (14) der Seitenwände (13) der Verbindungsstücke (11) ausreichend geschärft sind, um in den Verbindungsanschluß in der Verbindungsschaltung (5) einzudringen, der über dem ersten Schaltungsmuster (3) in dem flachen Kabel (1) liegt.

8. Verbindungsanordnung nach einem der vorhergehenden Ansprüche, bei dem der Abstand zwischen zwei benachbarten Verbindungsanschlüssen (9) im wesentlichen gleich groß ist wie der der passend angeordneten Schaltungsstreifen (4a- 4g) des ersten Schaltungsmusters (3) im flachen Kabel (1).

## Revendications

1. Un agencement de connexion électrique pour câble plat (1) comprenant:
une région de connexion du câble plat (1) où un premier motif de circuit électriquement conducteur (3) comprenant des bandes alignées sensiblement parallèles (4a-4g) est formé sur au moins un côté d'une feuille électriquement isolante (2) en une matière synthétique polymère;
un circuit de connexion (5) comprenant un second motif de circuit électriquement conducteur (7) formé sur une seconde feuille isolante (6) en une matière synthétique polymère avec ou sans une autre feuille isolante disposée par dessus, ledit second motif de circuit (7) comprenant des portions de circuit d'interconnexion (8) qui croisent au moins deux bandes parallèles (4a-4g) du premier motif de circuit électriquement conducteur sous-jacent (3) quand la seconde feuille isolante (6) est placée par dessus la première feuille isolante (2);
une pluralité de broches de connexion en forme de U (11) en un métal électriquement conducteur pour établir un contact électrique entre les premier et second motifs de circuits électriquement conducteurs (3, 5) quand ils ont été placés face à face avec entre eux au moins l'une desdites feuilles électriquement isolantes (2, 6), de manière que chacune des parois latérales (13) des broches de connexion (11) commence par passer à travers une paire de portions de circuit associées verticalement dans les deux motifs de circuits (3, 5) respectivement, et ensuite les parois latérales (13) sont repliées vers l'intérieur par compression de manière que les portions d'extrémité supérieures (14) des parois latérales repliées (13) s'enfoncent dans les circuits conducteurs électriques du second motif de circuit électriquement conducteur (5) du câble plat, respectivement, tandis que les portions inférieures plates (12) des broches de connexion (11) sont pressées contre les portions de circuit correspondantes du premier motif de circuit (3).

2. L'agencement de connexion selon la revendication 1, dans lequel le second circuit électriquement conducteur (5) est composé par au moins une paire de portions de circuit électrique d'interconnexion (8) et par au moins une paire de bornes de connexion (9).

3. L'agencement de connexion selon la revendication 2, dans lequel les portions (8) du circuit électrique d'interconnexion sont en alignement le long d'une ligne qui est perpendiculaire à la direction du premier circuit électriquement conducteur sous-jacent (3).

4. L'agencement de connexion selon la revendication 1, 2 ou 3, dans lequel les deux feuilles isolantes (2, 6) sont réalisées en la même matière thermoplastique polymère, et peuvent être reliées l'une à l'autre soit par fusion thermique sur leurs surfaces en regard soit par des adhésifs appropriés sous pression avant d'établir la connexion électrique entre les motifs de circuits (3, 5) qui sont formés respectivement sur chacune des feuilles isolantes (2, 6).

5. L'agencement de connexion selon l'une quelconque des revendications précédentes, dans lequel la position en face à face des deux motifs des circuits électriquement conducteurs (3, 5) est ajustée au moyen d'au moins deux paires de perforations (10) constituées dans chacune des feuilles isolantes (3, 5) qui sont en face à face.

6. L'agencement de connexion selon l'une quelconque des revendications précédentes, dans lequel la broche de connexion (11) comprend des coins (16) à sa partie inférieure, lesdits coins (16) étant pressés dans le circuit électrique du câble plat.

7. L'agencement de connexion selon l'une quelconque des revendications précédentes, dans lequel les portions supérieures (14) des parois latérales (13) des broches de connexion (11) sont suffisamment aiguisées pour s'enfoncer dans la borne de connexion du circuit de connexion (5) qui est disposé au-dessus du premier motif de circuit (3) du câble plat (1).

8. L'agencement de connexion selon l'une quelconque des revendications précédentes, dans lequel l'espace entre deux bornes de connexion adjacentes (3) est sensiblement égal à celui des bandes de circuit associées (4a-4g) du premier motif de circuit (3) du câble plat (1).
